# EUROPEAN PATENT SPECIFICATION

(11) **EP 2 224 605 B1**
(45) Date of publication and mention of the grant of the patent: **10.08.2016**
(21) Application number: 10163909.4
(22) Date of filing: 18.10.2005
(51) Int. Cl.: H04B 3/32

(54) **COMMUNICATIONS JACK WITH COMPENSATION FOR DIFFERENTIAL TO DIFFERENTIAL AND DIFFERENTIAL TO COMMON MODE CROSSTALK**
GESTEUERTER MODUSWANDLUNGSVERBINDER ZUR VERMINDERUNG VON FREMDÜBERSPRECHUNGEN
CONNECTEUR COMMANDE DE CONVERSION DE MODE POUR MINIMISER LA DIAPHONIE ÉTRANGÈRE

(30) Priority: 07.12.2004 US 633783 P; 16.12.2004 US 636599 P; 16.12.2004 US 636590 P; 28.01.2005 US 648002 P; 23.03.2005 US 88044
(43) Date of publication of application: 01.09.2010
(62) Divisional of application: 05813757.1
(73) Proprietor: Commscope Inc. of North Carolina, Sparks, NV 89431-6131 (US)
(72) Inventor: Hashim, Amid, Plano, TX 75093 (US)
(74) Representative: Popp, Eugen

(56) References cited:
- EP-A2- 1 191 646
- US-A- 5 310 363
- US-A- 5 328 390
- US-A- 5 362 257
- US-A- 6 102 730
- US-B1- 6 270 381

## Description

### Field of the Invention

The present invention relates generally to communication connectors and more particularly to near-end crosstalk (NEXT) and far-end crosstalk (FEXT) compensation in communication connectors.

### Background of the Invention

In an electrical communication system, it is sometimes advantageous to transmit information signals (video, audio, data) over a pair of wires (hereinafter "wire-pair" or "differential pair") rather than a single wire, wherein the transmitted signal comprises the voltage difference between the wires without regard to the absolute voltages present. Each wire in a wire-pair is susceptible to picking up electrical noise from sources such as lightning, automobile spark plugs and radio stations to name but a few. Because this type of noise is common to both wires within a pair, the differential signal is typically not disturbed. This is a fundamental reason for having closely spaced differential pairs.

Of greater concern, however, is the electrical noise that is picked up from nearby wires or pairs of wires that may extend in the same general direction for some distances and not cancel differentially on the victim pair. This is referred to as crosstalk. Particularly, in a communication system involving networked computers, channels are formed by cascading plugs, jacks and cable segments. In such channels, a modular plug often mates with a modular jack, and the proximities and routings of the electrical wires (conductors) and contacting structures within the jack and/or plug also can produce capacitive as well as inductive couplings that generate near-end crosstalk (NEXT) (i.e., the crosstalk measured at an input location corresponding to a source at the same location) as well as far-end crosstalk (FEXT) (i.e., the crosstalk measured at the output location corresponding to a source at the input location). Such crosstalks occur from closely-positioned wires over a short distance. In all of the above situations, undesirable signals are present on the electrical conductors that can interfere with the information signal. When the same noise signal is added to each wire in the wire-pair, the voltage difference between the wires will remain about the same and differential cross-talk is not induced, while at the same time the average voltage on the two wires with respect to ground reference is elevated and common mode crosstalk is induced. On the other hand, when an opposite but equal noise signal is added to each wire in the wire pair, the voltage difference between the wires will be elevated and differential crosstalk is induced, while the average voltage on the two wires with respect to ground reference is not elevated and common mode crosstalk is not induced.

U.S. Pat. No. 5,997,358 to Adriaenssens et al. (hereinafter "the '358 patent") describes a two-stage scheme for compensating differential to differential NEXT for a plug jack combination. Connectors described in the '358 patent can reduce the internal NEXT (original crosstalk) between the electrical wire pairs of a modular plug by adding a fabricated or artificial crosstalk, usually in the jack, at one or more stages, thereby canceling or reducing the overall crosstalk for the plug-jack combination. The fabricated crosstalk is referred to herein as a compensation crosstalk. This idea can often be implemented by twice crossing the path of one of the differential pairs within the connector relative to the path of another differential pair within the connector, thereby providing two stages of NEXT compensation. This scheme can be more efficient at reducing the NEXT than a scheme in which the compensation is added at a single stage, especially when the second and subsequent stages of compensation include a time delay that is selected to account for differences in phase between the offending and compensating crosstalk. This type of arrangement can include capacitive and/or inductive elements that introduce multi-stage crosstalk compensation, and is typically employed in jack lead frames and PWB structures within jacks. These configurations can allow connectors to meet "Category 6" performance standards set forth in ANSI/EIA/TIA 568, which are primary component standards for mated plugs and jacks for transmission frequencies up to 250MHz.

European Patent Application No. 1 191 646 A2 discloses a wiring board for a communications jack that includes a dielectric mounting substrate; first, second, third and fourth pairs of contact wires mounted in the mounting substrate, each of the contact wires including a fixed end portion mounted in the mounting substrate and a free end portion, where the contact wires of the first pair are immediately adjacent to each other and are sandwiched inside the third pair, the contact wires of the second pair are immediately adjacent to each other, the contact wires of the fourth pair are immediately adjacent to each other, and the second and fourth pairs sandwich the third pair. Crosstalk compensation circuitry is included on the wiring board that allows achievement of Category 6 crosstalk performance levels.

U.S. Patent No. 6,270,381 to Adriaenssens et al. discloses an RJ-45 communications jack that includes a housing having a plug aperture and eight contact wires that form or are part of eight conductive paths through the jack. The eight conductive paths form four differential pairs of conductive paths that are arranged according to the TIA/EIA industry standards. A portion of the first differential pair of conductive paths is sandwiched between the conductive paths of the third differential pair. This patent discloses at FIGS. 7 and 9 that the third differential pair of conductive paths may include one or more crossovers.

Alien NEXT is the differential crosstalk that occurs between communication channels. Obviously, physical separation between jacks will help and/or typical crosstalk approaches may be employed. However, a problem case may be "pair 3" of one channel crosstalking to "pair 3" of another channel, even if the pair 3 plug and jack wires in each channel are remote from each other and the only coupling occurs between the routed cabling. To reduce this form of alien NEXT, shielded systems containing shielded twisted pairs or foiled twisted pair configurations may be used. However, the inclusion of shields can increase cost of the system. Another approach to reduce or minimize alien NEXT utilizes spatial separation of cables within a channel and/or spatial separation between the jacks in a channel. However, this is typically impractical because bundling of cables and patch cords is common practice due to "real estate" constraints and ease of wire management.

In spite of recent strides made in improving mated connector (i.e., plug-jack) performance, and in particular reducing crosstalk at elevated frequencies (e.g., 500 MHz - see U.S. Patent Application Serial No. 10/845,104, entitled NEXT High Frequency Improvement by Using Frequency Dependent Effective Capacitance, filed May 4, 2004), channels utilizing connectors that rely on either these teachings or those of the '358 patent can still exhibit unacceptably high alien NEXT at very high frequencies (e.g., 500 MHz). As such, it would be desirable to provide connectors and channels used thereby with reduced alien NEXT at very high frequencies.

### Summary of the Invention

The present invention can provide communications jacks with improved differential to common mode and differential to differential NEXT and FEXT performance, particularly at high frequencies. The present invention is directed to a communications jack according to claim 1.

### Brief Description of the Figures

**Figure 1** is an exploded perspective view of a prior art communications jack.
**Figure 1A** is an enlarged perspective view of the prior art communications jack of **Figure 1****.**
**Figure 1B** is a top view of the wiring board of **Figure 1A****.**
**Figure 2** is a side view of contact wires of the jack of **Figure 1****.**
**Figure 3** is a top schematic view of contact wires of the prior art jack of **Figure 1****.**
**Figure 4** is a top schematic view of contact wires of an embodiment of a communications jack according to the present invention.
**Figure** 5 is an enlarged perspective view of contact wires following the configuration illustrated in **Figure 4** according to embodiments of the present invention.
**Figure 6** is an enlarged side view of contact wires of **Figure 5** in a wiring board.
**Figure 7** is a perspective view of a communications jack that includes the contact wires of **Figure 5** according to embodiments of the present invention.
**Figure 7A** is an enlarged perspective view of the communications jack of **Figure 7****.**
**Figures 8A-8D** are graphs plotting forward and reverse differential to common mode NEXT and FEXT as a function of frequency for pairs 3 and 2.
**Figures 9A-9D** are graphs plotting forward and reverse differential to common mode NEXT and FEXT as a function of frequency for pairs 3 and 4.

### Detailed Description of Embodiments of the Invention

The present invention will be described more particularly hereinafter with reference to the accompanying drawings. The invention is not intended to be limited to the illustrated embodiments; rather, these embodiments are intended to fully and completely disclose the invention to those skilled in this art. In the drawings, like numbers refer to like elements throughout. Thicknesses and dimensions of some components may be exaggerated for clarity.

Unless otherwise defined, all technical and scientific terms used herein have the same meaning as commonly understood by one of ordinary skill in the art to which this invention belongs. The terminology used in the description of the invention herein is for the purpose of describing particular embodiments only and is not intended to be limiting of the invention. As used in the description of the invention and the appended claims, the singular forms "a", "an" and "the" are intended to include the plural forms as well, unless the context clearly indicates otherwise. As used herein, the term "and/or" includes any and all combinations of one or more of the associated listed items.

This invention is directed to communications connectors, with a primary example of such being a communications jack. As used herein, the terms "forward", "forwardly", and "front" and derivatives thereof refer to the direction defined by a vector extending from the center of the jack toward the plug opening of the jack. Conversely, the terms "rearward", "rearwardly", and derivatives thereof refer to the direction directly opposite the forward direction; the rearward direction is defined by a vector that extends away from the plug opening toward the remainder of the jack. The terms "lateral," "laterally", and derivatives thereof refer to the direction generally parallel with the plane defined by a wiring board on which jack contact wires are mounted and extending away from a plane bisecting the plug in the center. The terms "medial," "inward," "inboard," and derivatives thereof refer to the direction that is the converse of the lateral direction, i.e., the direction parallel with the plane defined by the wiring board and extending from the periphery of the jack toward the aforementioned bisecting plane. Where used, the terms "attached", "connected", "interconnected", "contacting", "mounted" and the like can mean either direct or indirect attachment or contact between elements, unless stated otherwise. Where used, the terms "coupled," "induced" and the like can mean non-conductive interaction, either direct or indirect, between elements or between different sections of the same element, unless stated otherwise.

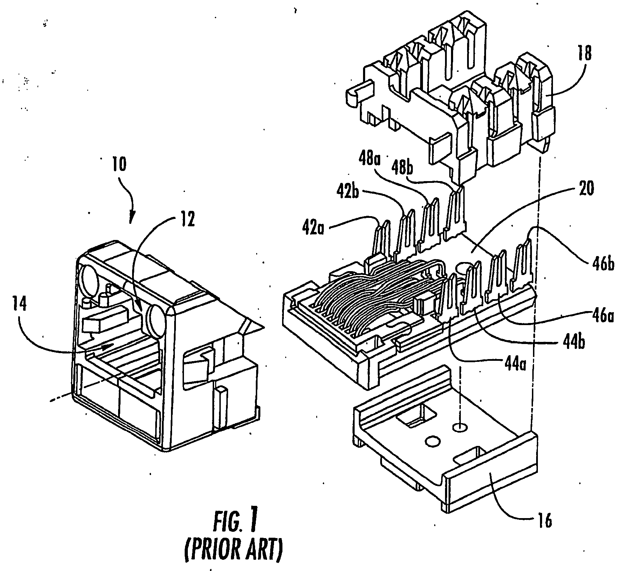

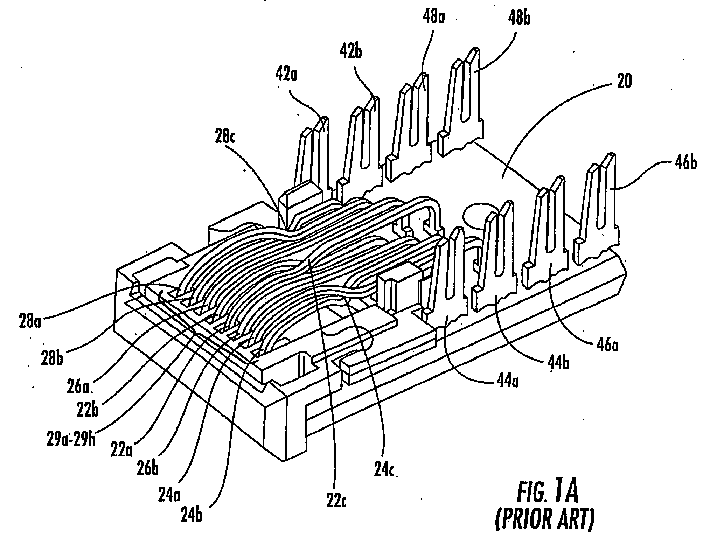

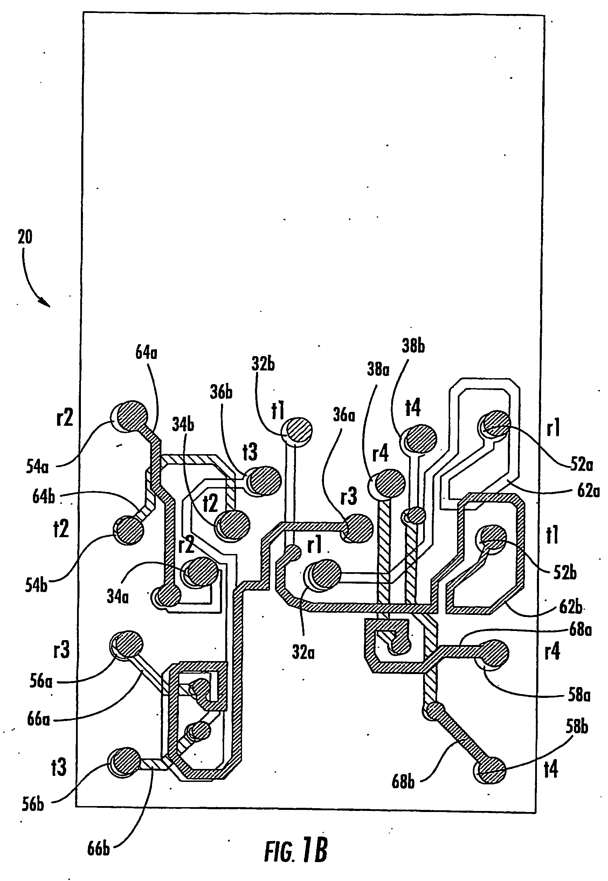

Referring now to the figures, a prior art jack, designated broadly at **10,** is illustrated in **Figures 1** and **1A**. The jack **10** includes a jack frame **12** having a plug aperture **14** for receiving a mating plug, a cover **16** and a terminal housing **18.** These components are conventionally formed and not need be described in detail herein; for a further description of these components and the manner in which they interconnect, see U.S. Patent No. 6,350,158 to Arnett et al. Those skilled in this art will recognize that other configurations of jack frames, covers and terminal housings may also be employed with the present invention. Exemplary configurations are illustrated in U.S. Patent Nos. 5,975,919 and 5,947,772 to Arnett et al. and U.S. Patent No. 6,454,541 to Hashim et al.

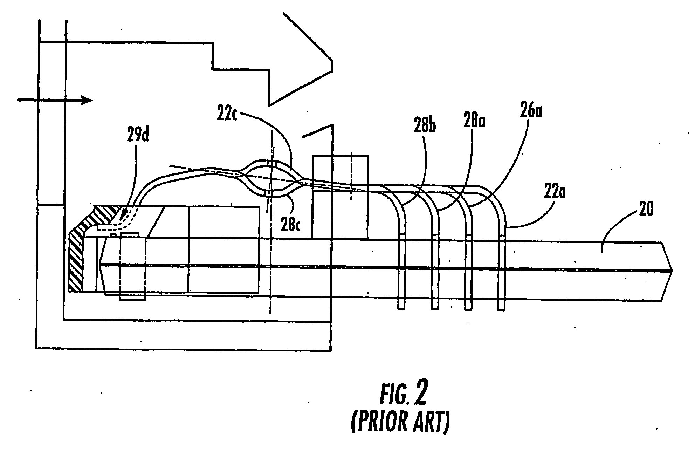

In addition, referring still to **Figure 1** and also to **Figure 2****,** the jack **10** further includes a wiring board 20 formed of conventional materials. The wiring board **20** may be a single layer board or may have multiple layers. The wiring board 20 may be substantially planar as illustrated, or may be non-planar.

Referring again to **Figures 1** and **1A****,** contact wires **22a, 22b, 24a, 24b, 26a, 26b, 28a, 28b** are attached to the wiring board **20.** As described in U.S. Patent No. 6,350,158 referenced above, the contact wires **22a, 22b, 24a, 24b, 26a, 26b, 28a, 28b** have free ends that have substantially the same profile, are substantially transversely aligned in side-by-side relationship, and that extend into the plug aperture **14** to form electrical contact with the terminal blades of a mating plug. The free ends of the contact wires **22a, 22b, 24a, 24b, 26a, 26b, 28a, 28b** extend into individual slots **29a-29h** in the forward edge portion of the wiring board **20.** The contact wires **22a, 22b, 24a, 24b, 26a, 26b, 28a, 28b** are arranged in pairs defined by TIA 568B, with wires **22a, 22b (pair** 1) being adjacent to each other and in the center of the sequence of wires, wires **24a, 24b** (pair 2) being adjacent to each other and occupying the leftmost two positions (from the vantage point of **Figure 1B**) in the sequence, wires **28a, 28b** (pair 4) being adjacent to each other and occupying the rightmost two positions (from the vantage point of **Figure 1B**) in the sequence, and wires **26a, 26b** (pair 3) being positioned between, respectively, pairs 1 and 4 and pairs 1 and 2. The wires **22a, 22b, 24a, 24b, 26a, 26b, 28a, 28b** are mounted to the wiring board **20** via insertion into respective apertures **32a, 32b, 34a, 34b, 36a, 36b, 38a, 38b,** which are arranged in the illustrated embodiment in a "dual diagonal" pattern known to those skilled in this art as described in U.S. Patent No. 6,196,880 to Goodrich et al. Those skilled in this art will appreciate that contact wires or other contacts of other configurations may be used. As one example, contact wires configured as described in aforementioned U.S. Patent No. 5,975,919 to Arnett et al. may be employed.

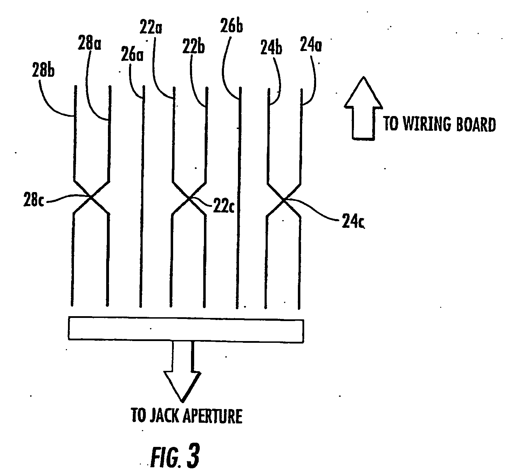

As can be seen in **Figures 1A** and **3****,** each of pairs 1, 2 and 4 that comprise adjacent contact wires include a respective "crossover" **22c, 24c, 28c,** i.e., a location in which the contact wires of a pair cross each other without making electrical contact, typically such that the free end of one contact wire of the pair is substantially longitudinally aligned with the fixed end portion of the other contact wire of the pair. The crossovers **22c, 24c, 28c** are located approximately in the center of their contact wires (between the free ends of the contact wires and their mounting locations on the wiring board **20**). Crossovers are included to provide compensatory crosstalk between contact wires. In the illustrated embodiment, the crossovers are implemented via complementary localized bends in the crossing wires, with one wire being bent upwardly and the other wire being bent downwardly. The presence of a crossover, structural implementations thereof, and its effect on crosstalk are discussed in some detail in the '358 patent described above and U.S. Patent No. 5,186,647 to Denkmann et al. In this prior art device, the contact wires of pair 3 (wires **26a, 26b**) do not include a crossover.

Referring once again to **Figures 1** and **1A** and to **Figure 1B****,** eight insulation displacement connectors (IDCs) **42a, 42b, 44a, 44b, 46a, 46b, 48a, 48b** are inserted into eight respective IDC apertures **52a, 52b, 54a, 54b, 56a, 56b, 58a, 58b.** The IDCs are of conventional construction and need not be described in detail herein; exemplary IDCs are illustrated and described in U.S. Patent No. 5,975,919 to Arnett, the disclosure of which is hereby incorporated by reference herein in its entirety.

Referring now to **Figures 1A****,** **1B** and **2****,** the each of the wire apertures **32a, 32b, 34a, 34b, 36a, 36b, 38a, 38b** is electrically connected to a respective IDC aperture **52a, 52b, 54a, 54b, 56a, 56b, 58a, 58b** via a respective conductor **62a, 62b, 64a, 64b, 66a, 66b, 68a, 68b,** thereby interconnecting each of the contact wires **22a, 22b, 24a, 24b, 26a, 26b, 28a, 28b** to its corresponding IDC **42a, 42b, 44a, 44b, 46a, 46b, 48a, 48b.** The conductors **62a, 62b, 64a, 64b, 66a, 66b, 68a, 68b** are formed of conventional conductive materials and are deposited on the wiring board **20** via any deposition method known to those skilled in this art to be suitable for the application of conductors. Some conductors are illustrated as being entirely present on a single layer of the wiring board **20** (for example, conductor **62a**), while other conductors (for example, conductor **62b**) may reside on multiple layers of the wiring board **20;** conductors can travel between layers through the inclusion of vias (also known as plated through holes) or other layer-transferring structures known to those skilled in this art.

U.S. Patent No. 5,967,853 to Hashim describes a technique whereby capacitive compensation is used to simultaneously compensate differential to differential and differential to common mode crosstalk. However, in order to effectively cancel both NEXT and FEXT it is typically necessary to provide both inductive and capacitive compensation. The prior art arrangement of contact wires disclosed in **Figures 1-3** has been proven to effectively and efficiently provide inductive differential to differential crosstalk compensation. However, it has been determined that this arrangement may be ineffective, and perhaps counterproductive, in providing inductive differential to common mode compensation in the jack 10. More specifically, the prior art arrangement provides inductive differential to differential crosstalk compensation between pairs 1 and 3, pairs 2 and 3, and pairs 4 and 3, but in the development of the present invention it has been recognized that, due to the large physical separation between the conductors of pair 3 and their asymmetric placement relative to pair 2 (and similarly to pair 4), the highest levels of differential to common mode crosstalk in a mating plug, which can be the most problematic to channel performance, tend to occur on pairs 2 and 4 when pair 3 is excited differentially. The differential to common mode crosstalk occurring when any of the pairs 1, 2 and 4 is excited differentially tends to be much less severe, and consequently much less problematic, because the separation between the conductors in each of these pairs is one-third the separation between the conductors of pair 3. In the prior art arrangement of contact wires disclosed in **Figures 1-3****,** crossover on each of pairs 1, 2 and 4 inductively compensates for the less severe differential to common mode crosstalk occurring when any of these pairs is differentially excited. However, due to the absence of a crossover on pair 3, this arrangement not only fails to inductively compensate for the more severe common mode crosstalk on pairs 2 and 4 when pair 3 is differentially excited, but can actually exacerbate this problem. This is especially true when the jack receives a conventional plug such as the one illustrated in U.S. Patent No. 6,250,949 to Lin.

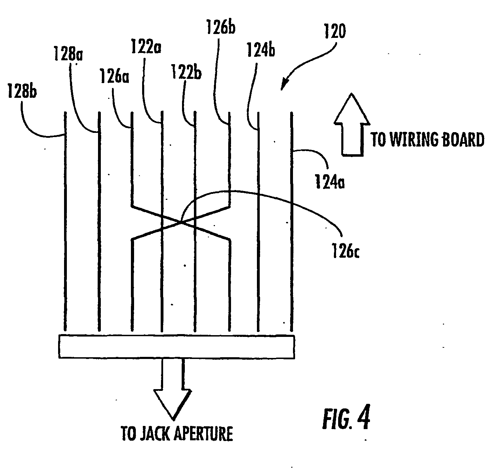

Turning now to **Figure 4****,** an arrangement of wires according to embodiments of the present invention, designated broadly at **120,** is illustrated schematically therein. The wiring arrangement **120** includes eight contact wires **122a, 122b, 124a, 124b, 126a, 126b, 128a, 128b** that comprise, respectively, wire pairs 1, 2, 3 and 4. In contrast to the prior art arrangement of contact wires described above, in this embodiment the contact wires **122a, 122b** of pair 1, the contact wires **124a, 124b** of pair 2, and the contact wires **128a, 128b** of pair 4 do not include a crossover, while the contact wires **126a, 126b** include a crossover **126c.**

Like the prior arrangement, this arrangement of contact wires should provide compensatory inductive differential to differential crosstalk between pairs 1 and 3, pairs 2 and 3, and pairs 4 and 3. In addition, this arrangement, although not inductively compensating for the less severe differential to common mode crosstalk occurring when any of the pairs 1, 2 and 4 is differentially excited, can provide inductive compensation for the highly problematic differential to common mode crosstalk occurring on pairs 2 and 4 when pair 3 is differentially excited. Because the most problematic differential to common mode crosstalk can be inductively compensated, a jack employing this arrangement can meet higher performance standards, particularly at elevated frequencies.

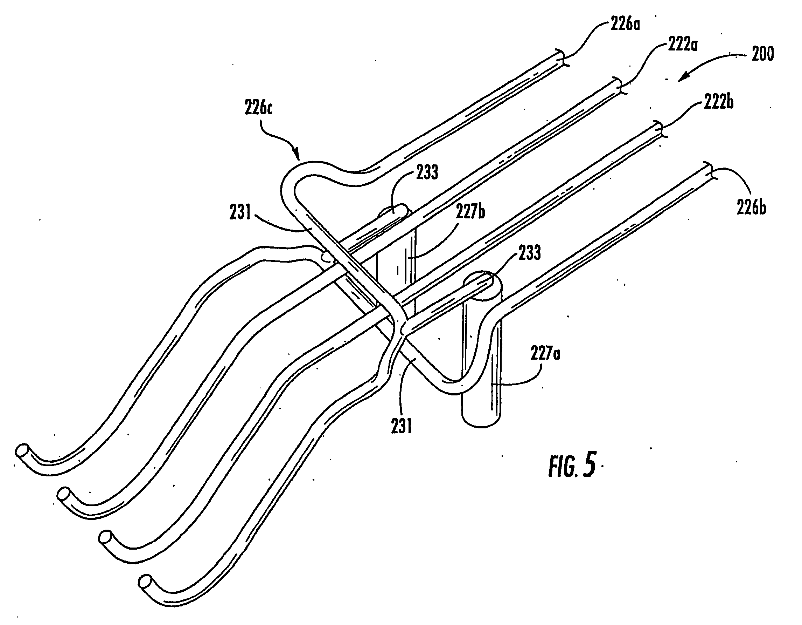

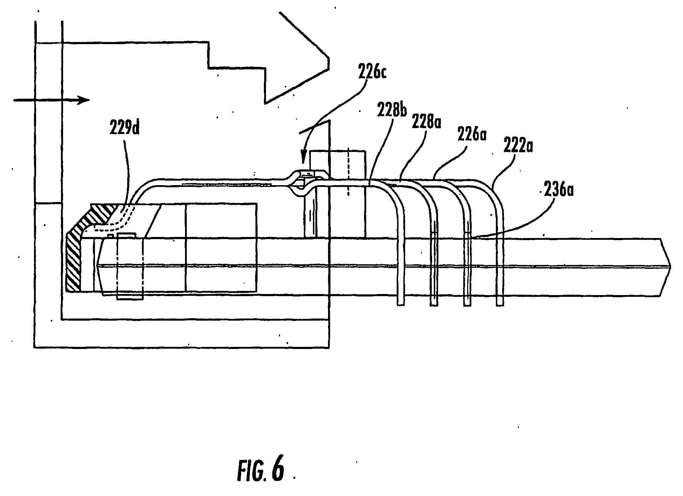

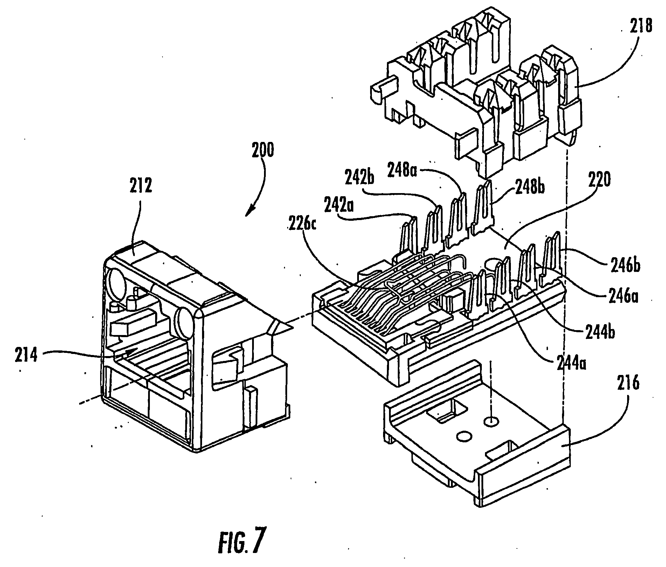

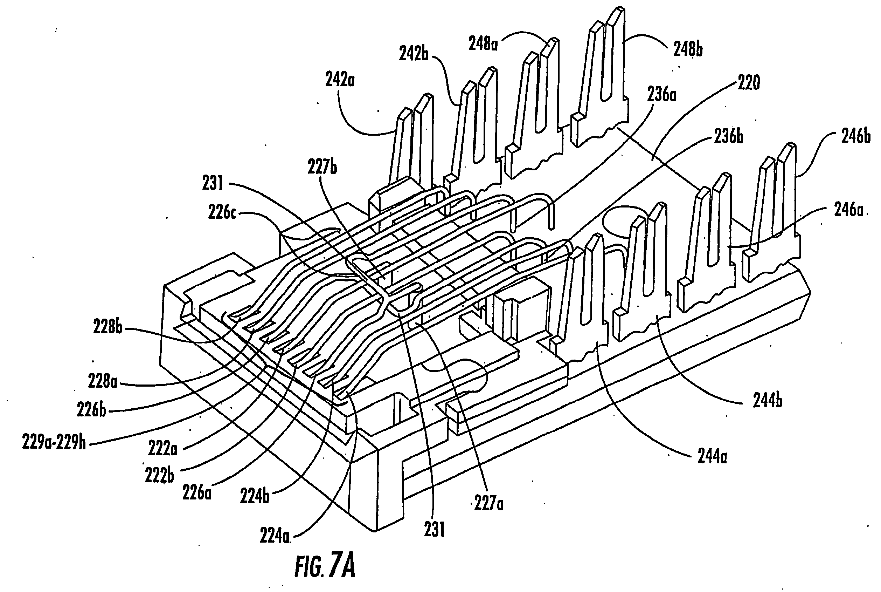

An exemplary implementation of this arrangement is illustrated in **Figures 5-7A****,** in which a jack **200** according to embodiment of the present invention is shown. The jack **200** includes a jack frame **212** having a plug aperture **214,** a cover **216** and a terminal housing **218.** A wiring board **220** includes IDCs **242a-248b** mounted thereon. Contact wires **222a-228b** are mounted to the wiring board **220.** At their free ends, the contact wires **222a-228b** fit within slots **229a-229h** located at the forward end of the wiring board **220** and are positioned to mate with the blades of a plug inserted into the plug aperture **214.** With the exception of the crossover region **226c,** described in greater detail below, the contact wires **222a-228b** follow generally the same profile until they bend downwardly into their respective mounting apertures in the wire board **220.** Conductive traces on the wiring board **220** provide signal paths between the contact wires **222a-228b** and the IDCs **242a-248b.**

Referring now to **Figure 5****,** the contact wires **226a, 226b** form the crossover **226c** with the assistance of supports **227a, 227b.** Each of the contact wires **226a, 226b** includes a transversely-extending crossover segment **231** that travels either over (in the case of the contact wire **226a**) or under (in the case of contact wire **226b**) the contact wires **222a, 222b.** Each of the contact wires **226a, 226b also** includes a support finger **233** that extends rearwardly from the crossover segment **231** to rest atop a respective support **227a, 227b.** The supports **227a, 227b** extend upwardly from the wiring board **220** from locations approximately halfway between the free ends of the contact wires **226a, 226b** and their mounting locations **236a, 236b** in the wiring board **220.** In some embodiments the support finger **233** of each contact wire **226a, 226b** may extend from its crossover segment at substantially the same angle, such that the supports **227a, 227b are** of different heights in order to support the crossover segment **231** of each contact wire **226a, 226b** at the proper elevation. In other embodiments, the supports **227a, 227b** may be of the same height, and the support finger **231** of each crossover segment may extend therefrom at different angles, or the supports may be of different heights and the fingers may extend at different angles.

This configuration enables the free ends of the contact wires **226a, 226b** to deflect in response to the insertion of a plug in the plug aperture **214** without contacting the contact wires **222a, 222b.** The illustrated embodiment has the advantage of enabling the commencement of the inductive differential to differential and differential to common mode compensations at minimal delay from the corresponding crosstalk sources, which can be important to effective crosstalk compensation. The separation between the crossover segments **231** and the locations where the contact wires **222a, 222b** intercept a mating plug is about 0.391 cm (0:154 inches), but those skilled in this art will appreciate that a separation gap of a different size may also be suitable with the present invention. Typically the contact wires are between about 1.65 and 2.10 cm (0.648 and 0.828 inches) in length, and the crossover **226c** occurs between about 0.76 and 1.01 cm (0.3 and 0.4 inches) from the free ends of the contact wires **226a, 226b.**

The skilled artisan will recognize that, although eight contact wires are illustrated and described herein, other numbers of contact wires may be employed. For example, 16 contact wires may be employed, and one or more crossovers that cross over a pair of contact wires sandwiched therebetween may be included in those contact wires.

Further, those skilled in this art will recognize that other jack configurations may also be suitable for use with the present invention. For example, as discussed above, other configurations of jack frames, covers and terminal housings may also be employed with the present invention. As another example, the contact wires may have a different profile (an exemplary alternative profile is depicted in U.S. Patent No. 5,975,919 to Arnett et al.), or they may by replaced by conductive paths on a flexible circuit, and they may mount in locations that do not follow the "dual diagonal" mounting scheme illustrated herein (an exemplary alternative is illustrated in U.S. Patent No. 6,116,964 to Goodrich et al). As a further example, the IDCs may mount in a different pattern on the wiring board, or some other type of connector may be used. Those skilled in this art will also recognize that embodiments of the wiring board described above may be employed in other environments in which a communications jack may be found. For example, jacks within a patch panel or series of patch panels may be suitable for use with such wiring boards. Other environments may also be possible.

Moreover, those skilled in this art will further recognize that the crossover of pair 3 described above can be implemented, with similar beneficial effect on differential to common mode crosstalk conversion, by forming the conductor leads of jacks utilizing metallic leadframe structures instead of printed wiring boards to achieve the required connectivity and crosstalk compensation. In such a configuration, the contact wires and/or the insulation displacement connectors may be formed integrally with the conductors as unitary members.

The configuration illustrated and described herein can provide connectors, and in particular communications jacks, that exhibit improved crosstalk characteristics, particularly at elevated frequencies. For example, a connector such as that illustrated in **Figures 5-7A** and mated with a conventional plug may have channel alien NEXT of less than -60 dB power sum at 100 MHz, and less than -49.5 dB power sum at 500 MHz.
Also those skilled in the art wili recognize that in situations where it may not be critical to implement the differential to differential crosstalk compensation between pairs 3 and 2 and between pairs 3 and 4 in the contact wires, it is possible to provide instead compensation for the common mode crosstalk induced on pair 3, or pair 1, when either of pair 2 or pair 4 is differentially excited, by modifying the contact wire crossover scheme of Figure 4 to include crossovers in pairs 2 and 4 in addition to the crossover on pair 3.

Further, those skilled in the art will recognize the reciprocity that exists between the differential to common mode crosstalk induced on a first pair, when a second pair is excited differentially, and the common mode to differential signal induced on the second of these pairs when the first of these pairs is excited common-modally, with the common mode to differential crosstalk equaling the differential to common mode crosstalk multiplied by a constant, that constant being the ratio of the differential to common mode impedances. Consequently, when an improvement occurs, due to the current invention, in the differential to common mode crosstalk between two pairs when one of these pairs is excited differentially, a corresponding improvement occurs in the common mode to differential crosstalk between these two pairs, when the other of these pairs is excited common-modally.

The invention is described in greater detail herein in the following non-limiting example.

### EXAMPLE

Communication jacks of the configuration illustrated in Figure 1, mated with conventional plugs, were modeled and solved using finite element electromagnetic field simulation software. In one jack model designated "experimental jack", the contact wire crossover configuration substantially matched the embodiment of the current invention illustrated in **Figures 5-7A****.** In a second jack model, designated "prior art jack", the contact wire crossover configuration substantially matched the prior art jack illustrated in **Figures 1-****3.** The jack models were then solved for differential to common mode NEXT and FEXT crosstalk.

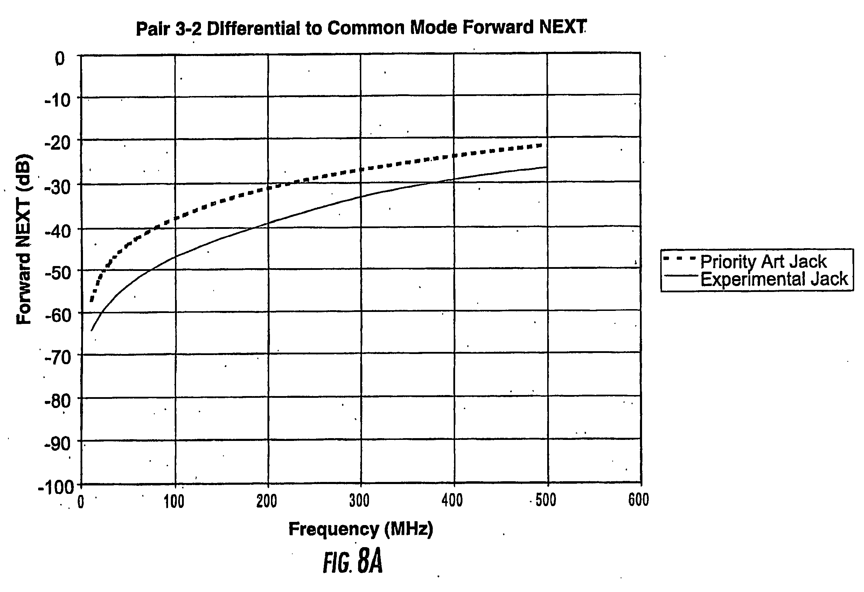

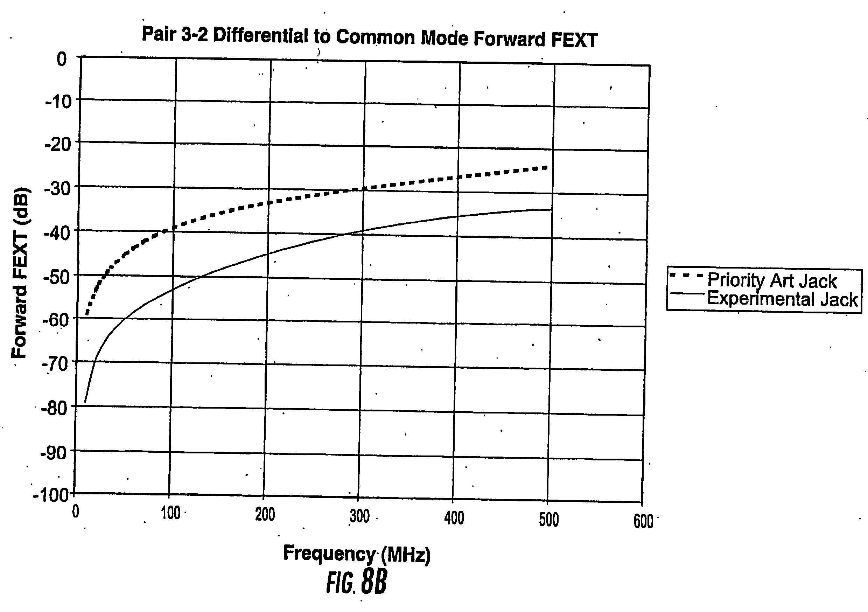

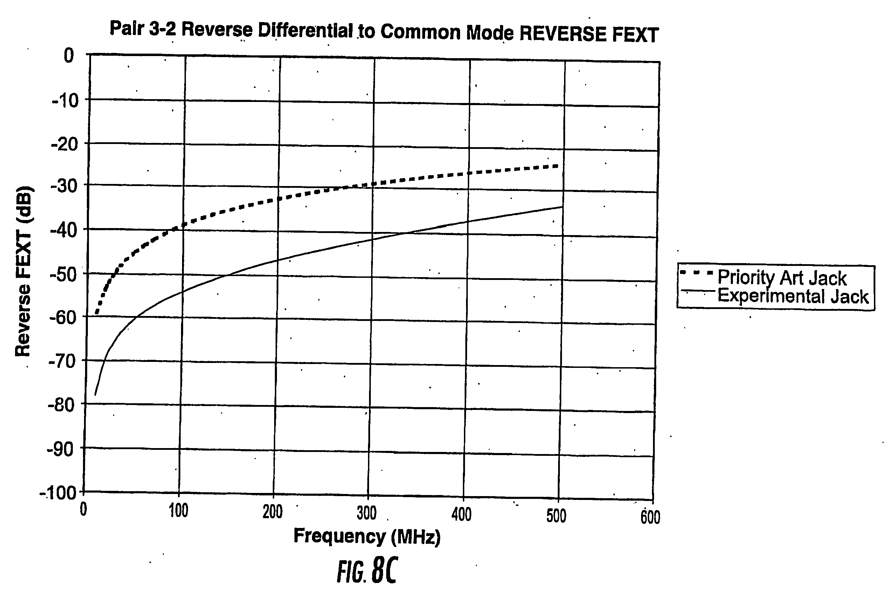

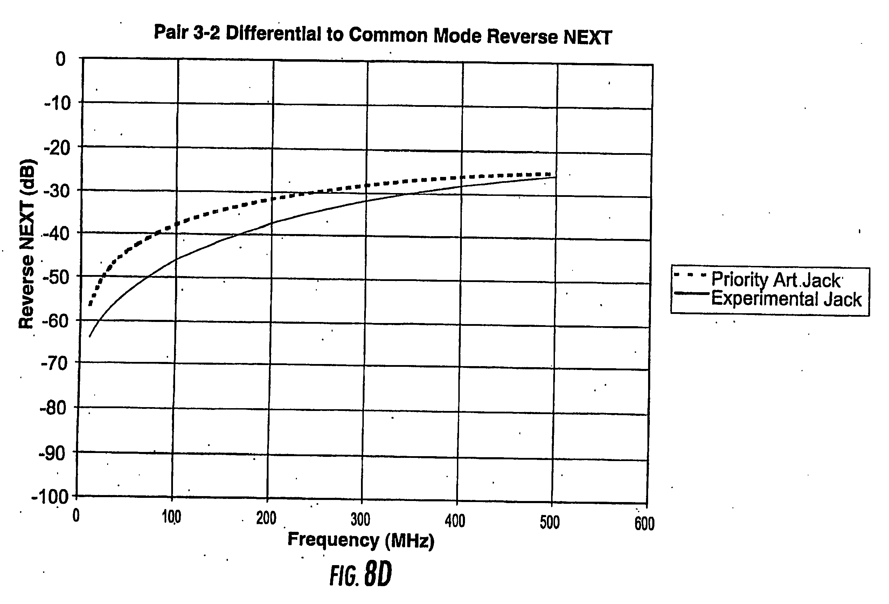

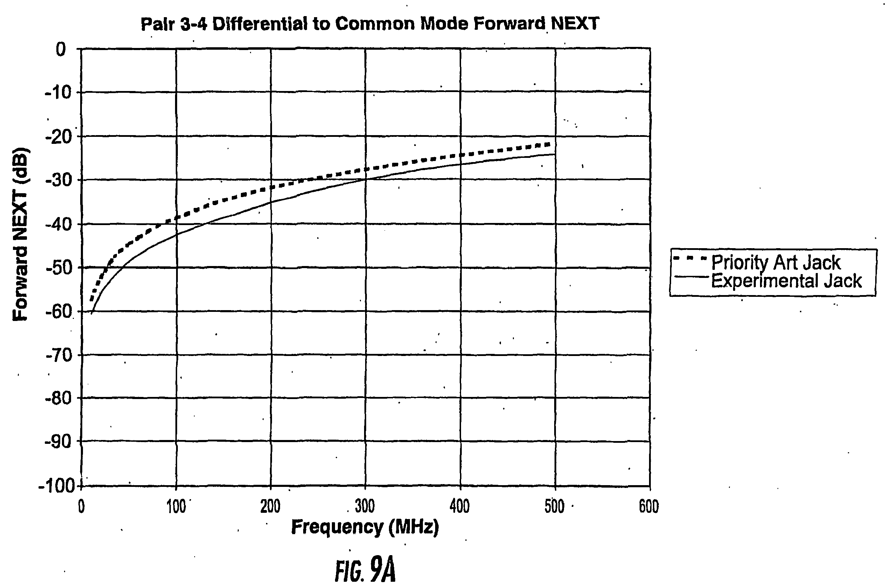

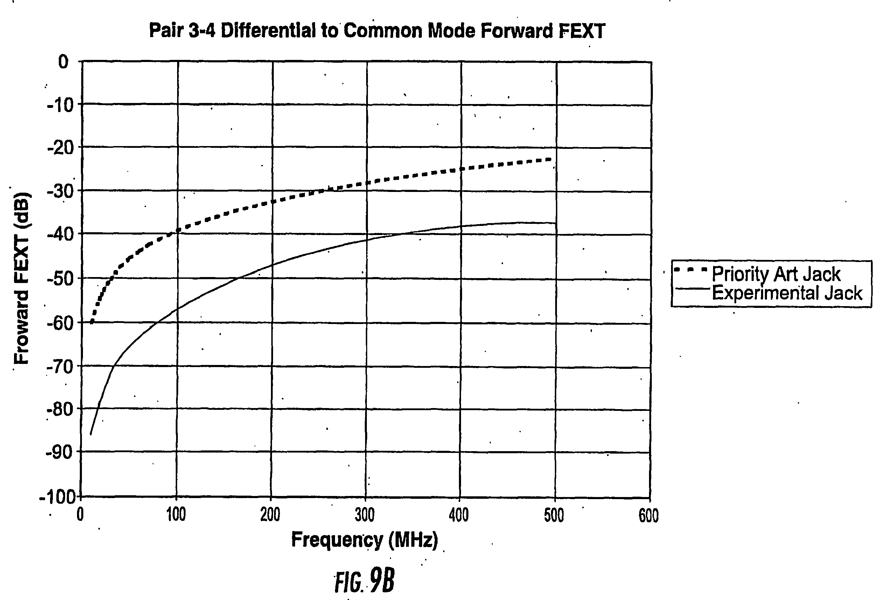

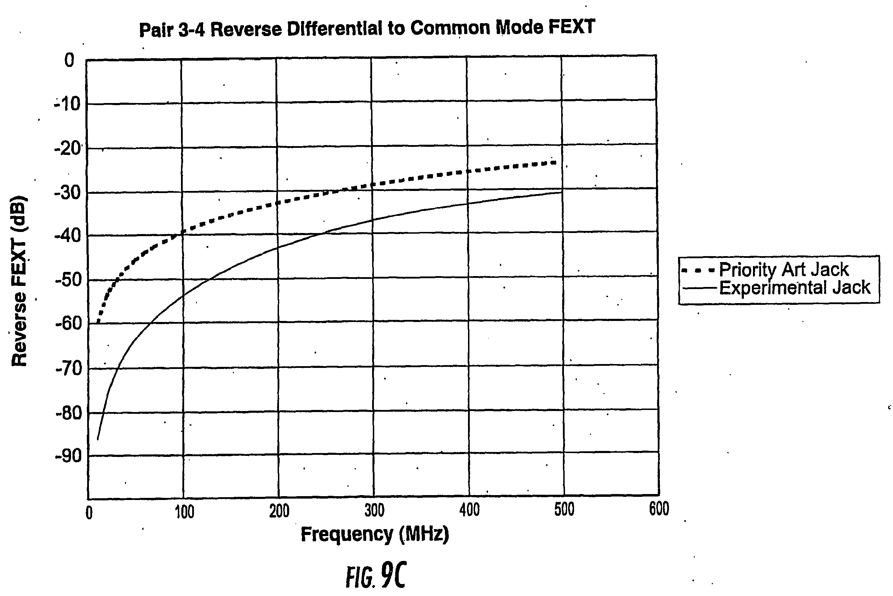

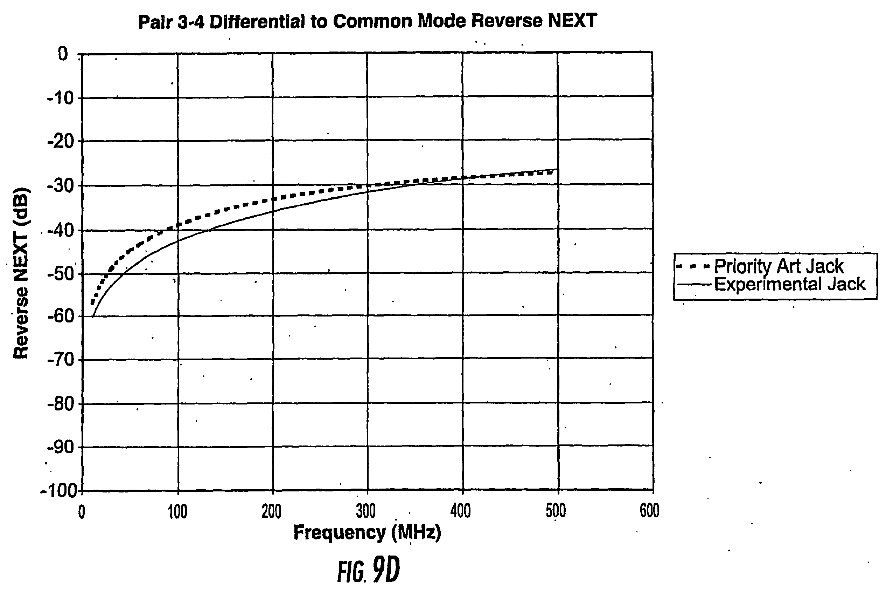

Differential to Common Mode Results for the problematic 3-2 and 3-4 pair combinations, where pair 3 is the differentially excited pair, are shown in **Figures 8A-8D** and **Figures 9A-9D****.** For each of these pair combinations results are provided for forward NEXT, forward FEXT, reverse FEXT and reverse NEXT, wherein the term "forward" represents the testing orientation in which the excitation is injected from the cordage end of the plug and term "reverse" represents the testing orientation in which the excitation is injected from building cable end of the jack. It can be seen that in all these cases the experimental jack employing the pair 3 crossover exhibited significant improvements in differential to common mode crosstalk (i.e. lower decibel levels) over the prior art jack, within the frequency band of interest of 10-500 MHz.

The foregoing is illustrative of the present invention and is not to be construed as limiting thereof. Although exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. The invention is defined by the following claims.

The preferred features of the present invention can be summarized as follows:

## Claims

1. A communications jack (200), comprising:
a housing (212) having a plug aperture (214);
a wiring board (220);
a first contact wire (222a) and a second contact wire (222b) that form a first differential pair of contact wires (222a, 222b), the first and second contact wires (222a, 222b) each having a fixed end portion that is mounted in the wiring board (220) and a free end; and
a third contact wire (226a) and a fourth contact wire (226b) that form a second differential pair of contact wires (226a, 226b), the third and fourth contact wires (226a, 226b) each having a fixed end portion that is mounted in the wiring board (220) and a free end;
wherein at least a portion of the first differential pair of contact wires (222a, 222b) is sandwiched in between the contact wires of the second differential pair of contact wires (226a, 226b), the communications jack **characterized in that**:
a crossover segment (231) of the third contact wire (226a) crosses over the first contact wire (222a), the second contact wire (222b) and the fourth contact wire (226b);
a crossover segment (231) of the fourth contact wire (226b) crosses under the first contact wire (222a), the second contact wire (222b) and the third contact wire (226a); and the jack (200) further includes
a first support structure (227a) that supports the third contact wire (226a) and a second support structure (227b) that supports the fourth contact wire (226b), wherein a support finger (233) extends away from each crossover segment (231);
wherein the first and second support structures (227a, 227b) support the respective support fingers (233) so that the free ends of the third and fourth contact wires (226a, 226b) are able to deflect in response to insertion of a plug into the plug aperture (214) without contacting the first or second contact wires (222a, 222b).

2. The communications jack (200) of Claim 1, wherein the crossover segment (231) of the third contact wire (226a) is between the fixed end portion of the third contact wire (226a) and a first of the support fingers (233).

3. The communications jack (200) of Claim 2, wherein the first support structure (227a) is on the wiring board (220).

4. The communications jack (200) of Claim 2, wherein the first of the support fingers (233) branches off of the third contact wire (226a) between the fixed end portion and the free end of the third contact wire (226a).

5. The communications jack (200) of Claim 2, wherein the crossover segment (231) of the fourth contact wire (226b) is between the fixed end portion of the fourth contact wire (226b) and a second of the support fingers (233).

6. The communications jack (200) of Claim 1, wherein the first and second support structures (227a, 227b) are mounted on the wiring board (220).

7. The communications jack (200) of Claim 1, further comprising a third differential pair of contact wires (224a, 224b) and a fourth differential pair of contact wires (228a, 228b).

8. The communications jack (200) of Claim 7, wherein only the second differential pair of contact wires (226a, 226b) includes a crossover.

9. The communications jack (200) of Claim 7, wherein neither of the third and fourth pairs of contact wires (224a, 224b; 228a, 228b) includes a crossover.

10. The communications jack (200) of Claim 1, wherein a free end portion of the third contact wire (226a) is longitudinally aligned with the fixed end portion of the fourth contact wire (226b).

11. The communications jack (200) of Claim 1, wherein the second support structure (227b) has a height that is less than a height of the first support structure (227a).

12. The communications jack (200) of Claim 1, wherein the third contact wire (226a) only crosses over the first and second contact wires (222a, 222b) one time, and wherein the fourth contact wire (226b) only crosses under the first and second contact wires (222a, 222b) one time.

13. The communications jack (200) of Claim 2, wherein the first crossover segment (231) is positioned at an angle that is substantially normal to a primary axis of the first contact wire (222a).

14. The communications jack (200) of Claim 1, wherein the third contact wire (226a) crosses over deflectable portions of the first, second and fourth contact wires (222a, 222b, 226b), and wherein the fourth contact wire (226b) crosses under deflectable portions of the first, second and third contact wires (222a, 222b, 226a).

## Patentansprüche

1. Kommunikationsstecker (200), welcher enthält:
ein Gehäuse (212), welches eine Steckerapertur (214) hat;
eine Verdrahtungsplatte (220);
einen ersten Kontaktdraht (222a) und einen zweiten Kontaktdraht (222b), welche ein erstes Differentialpaar aus Kontaktdrähten (222a, 222b) ausbilden, wobei der erste und zweite Kontaktdraht (222a, 222b) jeweils einen festgelegten Endabschnitt, welcher in der Verdrahtungsplatte (220) eingerichtet ist, und ein freies Ende haben; und
einen dritten Kontaktdraht (226a) und einen vierten Kontaktdraht (226b), welche ein zweites Differentialpaar aus Kontaktdrähten (226a, 226b) ausbilden, wobei der dritte und vierte Kontaktdraht (226a, 226b) jeweils einen festgelegten Endabschnitt, welcher in der Verdrahtungsplatte (220) eingerichtet ist, und ein freies Ende haben;
wobei zumindest ein Abschnitt von dem ersten Differentialpaar von Kontaktdrähten (222a, 222b) zwischen den Kontaktdrähten von dem zweiten Differentialpaar von Kontaktdrähten (222a, 222b) zwischengelegt ist, wobei der Kommunikationsstecker **dadurch gekennzeichnet ist, dass**:
ein Überkreuzungssegment (231) von dem dritten Kontaktdraht (226a) sich über dem ersten Kontaktdraht (222a), dem zweiten Kontaktdraht (222b) und dem vierten Kontaktdraht (226b) überkreuzt;
ein Überkreuzungssegment (231) von dem vierten Kontaktdraht (226b) sich unter dem ersten Kontaktdraht (222a), dem zweiten Kontaktdraht (222b) und dem dritten Kontaktdraht (226a) überkreuzt; und wobei der Stecker (200) ferner enthält:
eine erste Haltestruktur (227a), welche den dritten Kontaktdraht (226a) hält, und eine zweite Haltestruktur (227b), welche den vierten Kontaktdraht (226b) hält, wobei sich ein Haltefinger (233) von jedem Überkreuzungssegment (231) fort erstreckt;
wobei die erste und zweite Haltestruktur (227a, 227b) die jeweiligen Haltefinger (233) derart halten, dass die freien Enden von dem dritten und vierten Kontaktdraht (222a, 222b) dazu in der Lage sind, sich in Reaktion auf ein Einsetzen eines Steckers in die Steckerapertur (214) zu verbiegen, ohne mit dem ersten oder zweiten Kontaktdraht (222a, 222b) in Kontakt zu gelangen.

2. Kommunikationsstecker (200) nach Anspruch 1, bei welchem sich das Überkreuzungssegment (231) von dem dritten Kontaktdraht (226a) zwischen dem festgelegten Endabschnitt von dem dritten Kontaktdraht (226a) und einem ersten der Haltefinger (233) befindet.

3. Kommunikationsstecker (200) nach Anspruch 2, bei welchem sich die erste Haltestruktur (227a) auf der Verdrahtungsplatte (220) befindet.

4. Kommunikationsstecker (200) nach Anspruch 2, bei welchem sich der erste der Haltefinger (233) von dem dritten Kontaktdraht (226a) zwischen dem festgelegten Endabschnitt und dem freien Ende von dem dritten Kontaktdraht (226a) abzweigt.

5. Kommunikationsstecker (200) nach Anspruch 2, bei welchem sich das Überkreuzungssegment (231) von dem vierten Kontaktdraht (226b) zwischen dem festgelegten Endabschnitt von dem vierten Kontaktdraht (226b) und einem zweiten der Haltefinger (233) befindet.

6. Kommunikationsstecker (200) nach Anspruch 1, bei welchem die erste und zweite Haltestruktur (227a, 227b) auf der Verdrahtungsplatte (220) eingerichtet sind.

7. Kommunikationsstecker (200) nach Anspruch 1, welcher ferner ein drittes Differentialpaar von Kontaktdrähten (224a, 224b) und ein viertes Differentialpaar von Kontaktdrähten (228a, 228b) enthält.

8. Kommunikationsstecker (200) nach Anspruch 7, bei welchem lediglich das zweite Differentialpaar von Kontaktdrähten (222a, 222b) eine Überkreuzung enthält.

9. Kommunikationsstecker (200) nach Anspruch 7, bei welchem weder das dritte noch das vierte Paar von Kontaktdrähten (224a, 224b; 228a, 228b) eine Überkreuzung enthält.

10. Kommunikationsstecker (200) nach Anspruch 1, bei welchem ein freier Endabschnitt von dem dritten Kontaktdraht (226a) längstgerichtet zu dem festgelegten Endabschnitt von dem vierten Kontaktdraht (226b) ausgerichtet ist.

11. Kommunikationsstecker (200) nach Anspruch 1, bei welchem die zweite Haltestruktur (227b) eine Höhe hat, welche geringer ist als eine Höhe von der ersten Haltestruktur (227a).

12. Kommunikationsstecker (200) nach Anspruch 1, bei welchem sich der dritte Kontaktdraht (226a) lediglich einmal über dem ersten und zweiten Kontaktdraht (222a, 222b) überkreuzt, und wobei sich der vierte Kontaktdraht (226b) lediglich einmal unter dem ersten und zweiten Kontaktdraht (222a, 222b) überkreuzt.

13. Kommunikationsstecker (200) nach Anspruch 2, bei welchem das erste Überkreuzungssegment (231) bei einem Winkel positioniert ist, welcher im Wesentlichen senkrecht zu einer Primärachse von dem ersten Kontaktdraht (222a) ist.

14. Kommunikationsstecker (200) nach Anspruch 1, bei welchem sich der dritte Kontaktdraht (226a) über verbiegbare Abschnitte von dem ersten, zweiten und vierten Kontaktdraht (222a, 222b, 226b) überkreuzt, und sich der vierte Kontaktdraht (226b) unter verbiegbare Abschnitte von dem ersten, zweiten und dritten Kontaktdraht (222a, 222b, 226a) überkreuzt.

## Revendications

1. Prise de télécommunications (200), comprenant :
un boîtier (212) ayant une ouverture de broche (214) ;
une carte de câblage (220) ;
un premier fil de contact (222a) et un second fil de contact (222b) qui forment une première paire différentielle de fils de contact (222a, 222b), le premier et le second fil de contact (222a, 222b) ayant chacun une portion terminale fixe qui est montée dans la carte de câblage (220) et une extrémité libre ; et
un troisième fil de contact (226a) et un quatrième fil de contact (226b) qui forment une seconde paire différentielle de fils de contact (226a, 226b), le troisième et le quatrième fil de contact (226a, 226b) ayant chacun une portion d'extrémité fixe qui est montée dans la carte de câblage (220) et une extrémité libre ;
dans laquelle au moins une portion de la première paire différentielle de fils de contact (222a, 222b) est prise en sandwich entre les fils de contact de la seconde paire différentielle de fils de contact (226a, 226b), la prise de télécommunications étant **caractérisée en ce que** :
un segment de croisement (231) du quatrième fil de contact (226b) croise au-dessous du premier fil de contact (222a), du second fil de contact (222b) et du quatrième fil de contact (226a) ; et la prise (200) inclut en outre
une première structure de support (227a) qui supporte le troisième fil de contact (226a) et une seconde structure de support (227b) qui supporte le quatrième fil de contact (226b),
dans laquelle la première et la seconde structure de support (227a, 227b) supportent les doigts de support respectifs (233) de sorte que les extrémités libres du troisième et du quatrième fil de contact (226a, 226b) sont capables de se défléchir en réponse à l'insertion d'une prise dans l'ouverture de prise (214) sans venir en contact avec le premier ou le second fil de contact (222a, 222b).

2. Prise de télécommunications (200) selon la revendication 1, dans laquelle le segment de croisement (231) du troisième fil de contact (226a) est entre la portion d'extrémité fixe du troisième fil de contact (226a) et un premier des doigts de support (233).

3. Prise de télécommunications (200) selon la revendication 2, dans laquelle la première structure de support (227a) est sur la carte de câblage (220).

4. Prise de télécommunications (200) selon la revendication 2, dans laquelle le premier des doigts de support (233) est ramifié depuis le troisième fil de contact (226a) entre la portion d'extrémité fixe et l'extrémité libre du troisième fil de contact (226a).

5. Prise de télécommunications (200) selon la revendication 2, dans laquelle le segment de croisement (231) du quatrième fil de contact (226b) est entre la portion d'extrémité fixe du quatrième fil de contact (226b) et un second des doigts de support (233).

6. Prise de télécommunications (200) selon la revendication 1, dans laquelle la première et la seconde structure de support (227a, 227b) sont montées sur la carte de câblage (220).

7. Prise de télécommunications (200) selon la revendication 1, comprenant en outre une troisième paire différentielle de fils de contact (224a, 224b) et une quatrième paire différentielle de fils de contact (228a, 228b).

8. Prise de télécommunications (200) selon la revendication 7, dans laquelle seule la seconde paire différentielle de fils de contact (226a, 226b) inclut un croisement.

9. Prise de télécommunications (200) selon la revendication 7, dans laquelle ni la troisième ni la quatrième paire de fils de contact (224a, 224b ; 228a, 228b) inclut un croisement.

10. Prise de télécommunications (200) selon la revendication 1, dans laquelle une portion d'extrémité libre de troisième fil de contact (226a) est alignée longitudinalement avec la portion d'extrémité fixe du quatrième fil de contact (226b).

11. Prise de télécommunications (200) selon la revendication 1, dans laquelle la seconde structure de support (227b) a une hauteur qui est plus faible qu'une hauteur de la première structure de support (227a).

12. Prise de télécommunications (200) selon la revendication 1, dans laquelle le troisième fil de contact (226a) croise uniquement par-dessus le premier et le second fil de contact (222a, 222b) une fois, et dans laquelle le quatrième fil de contact (226b) croise uniquement par-dessous le premier et le second fil de contact (222a, 222b) une fois.

13. Prise de télécommunications (200) selon la revendication 2, dans laquelle le premier segment de croisement (231) est positionné sous un angle qui est sensiblement normal à un axe primaire du premier fil de contact (222a).

14. Prise de télécommunications (20) selon la revendication 1, dans laquelle le troisième fil de contact (226a) croise par-dessus des portions du premier, du second et du quatrième fil de contact (222a, 222b, 226b) capables de défléchir, et dans laquelle le quatrième fil de contact (226b) croise par-dessous des portions du premier, du second et du troisième fil de contact (222a, 222b, 226a) capables de défléchir.
